(19) **Europäisches Patentamt European Patent Office Office européen des brevets**

(11) **EP 3 786 801 A1**

(12) **DEMANDE DE BREVET EUROPEEN**

(43) Date de publication:
03.03.2021 Bulletin 2021/09

(51) Int Cl.:
*G06F 11/10* (2006.01)

(21) Numéro de dépôt: 20193012.0

(22) Date de dépôt: 27.08.2020

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: 29.08.2019 FR 1909492

(71) Demandeur: **Commissariat à l'Energie Atomique et aux Energies Alternatives 75015 Paris (FR)**

(72) Inventeurs:
• **GHERMAN, Valentin 38054 GRENOBLE (FR)**
• **EVAIN, Samuel 38054 GRENOBLE (FR)**

(74) Mandataire: **Marks & Clerk France Immeuble "Visium" 22, avenue Aristide Briand 94117 Arcueil Cedex (FR)**

(54) **PROCÉDÉ D'INVERSION SÉLECTIVE DE MOTS À ÉCRIRE DANS UNE MÉMOIRE ET DISPOSITIF POUR SA MISE EN ŒUVRE**

(57) L'invention concerne un procédé d'inversion sélective d'un mot à écrire dans une mémoire, la mémoire comprenant des cellules mémoire où chaque cellule mémoire permet de stocker au moins deux valeurs associées à au moins un bit, la décision d'inverser un mot étant prise en fonction d'un nombre de valeurs vulnérables qui est déterminé à partir des bits de données, du bit d'inversion et de bits de vérification impairs.

Figure 2

**Description**

L'invention se situe dans le domaine des mémoires, et concerne plus particulièrement un procédé et un dispositif d'inversion sélective de mots lors d'une opération d'écriture dans une mémoire.

Une mémoire est constituée d'une pluralité de cellules mémoire qui peuvent être des cellules mononiveau (SLC) pour « Single-Level Cell » en anglais, contenant un bit d'information qui peut prendre deux états électriques possibles, ou des cellules mémoire multi-niveaux (MLC) pour « Multi-Level Cell » en anglais, capables de stocker plus d'un bit d'information et prendre plus de deux états électriques. Ainsi, par exemple, les mémoires flash MLC NAND possèdent des cellules mémoire capables de stocker deux bits d'information par cellule et donc prendre quatre états électriques différents. D'autres mémoires permettent de stocker plus de deux bits par cellule, telles les mémoires TLC NAND pour « Triple Level Cell » en anglais qui offrent alors huit états électriques ou des mémoires MLC basées sur une technologie de quatre bits par cellule avec seize états électriques possibles.

Avoir plusieurs états électriques possibles dans une même cellule réduit la marge séparant les états et il en résulte une exposition aux erreurs.

Des changements de valeurs indésirables dans les cellules mémoire peuvent se produire lors des opérations d'écriture. Les changements peuvent se produire au sein d'une cellule devant être programmée et/ou sur des cellules voisines. En effet, les cellules mémoire étant toujours plus proches les unes des autres, les perturbations causées par les opérations d'écriture dans des cellules mémoires peuvent affecter des cellules voisines.

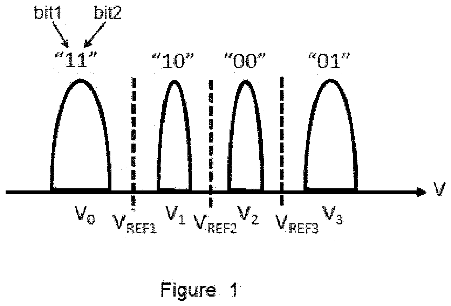

Des études ont démontré que la vulnérabilité aux erreurs dépend de la valeur qui est à stocker, mais aussi de la ou des valeurs déjà stockée(s) dans une cellule ou dans des cellules voisines. La figure 1 permet d'illustrer l'exposition aux erreurs pour une mémoire de type MLC capable de stocker deux bits par cellule illustrés par les références 'bit1 bit2' pouvant prendre les valeurs '11', '10', '00' et '01'. Dans des réalisations concrètes, chacun des deux bits peut appartenir à un mot mémoire différent. Ainsi dans une cellule mémoire, il peut y avoir quatre états d'une valeur observable V_cellule correspondant à une combinaison particulière des deux bits, où V_cellule peut être la tension de seuil d'une cellule mémoire de type flash ou la résistance électrique d'une cellule mémoire de type PCM (pour « Phase-Change Memory » en anglais). Lors d'une programmation complète d'une telle cellule mémoire, la valeur observable V_cellule prend des valeurs dans quatre domaines $V_0$, $V_1$, $V_2$, et $V_3$ correspondant respectivement aux combinaisons '11', '10', '00' et '01' des paires 'bit1 bit2' illustrés sur la figure 1.

Un scénario d'écriture / lecture d'une cellule multi-level comme illustrée peut être le suivant, en considérant que toutes les cellules sont à l'origine, par défaut, à la valeur 'bit1 bit2' = '11'. Pour programmer la première fois le premier bit 'bit1 ', si la valeur à écrire est '1', il n'y a pas besoin de programmation supplémentaire, mais si la valeur à programmer est '0', il y a lieu de passer du domaine $V_0$ (11) au domaine $V_2$ (00).

Pour programmer ensuite le deuxième bit 'bit2', il y a lieu de lire la valeur du premier bit 'bit1 ' pour permettre de déterminer comment passer du domaine courant au domaine souhaité. Lors d'une opération de lecture d'une cellule mémoire, une valeur observable V_cellule qui caractérise la tension de la cellule (et représentée par les quatre bosses des domaines $V_0$ à $V_3$ sur la figure 1) est mesurée et comparée à des valeurs de référence prédéfinies entre chaque paire de domaines voisins, illustrées par $V_{REF1}$, $V_{REF2}$, $V_{REF3}$ sur la figure 1. La comparaison permet de déterminer à quel domaine appartient la valeur mesurée et dès lors, de déterminer quelles sont les valeurs des deux bits stockés dans cette cellule mémoire. Aussi pour lire le premier bit, la tension V_cellule présente sur la cellule est comparée aux valeurs de référence. Si la tension V_cellule présente sur la cellule est inférieure à la tension de référence $V_{REF2}$, le premier bit est lu à 'bit1' = '1', et si la tension V_cellule présente sur la cellule est supérieure à la tension de référence $V_{REF2}$, le premier bit est lu à 'bit 1' = '0'.

Pour programmer le deuxième bit 'bit2' à '1', si le premier bit 'bit1' est lu à '1', il n'y a pas besoin de programmation supplémentaire afin de rester dans le domaine $V_0$ correspondant à la programmation '11'. Par contre, si le premier bit 'bit1' est lu à '0', il y a lieu de passer du domaine $V_2$ correspondant à la programmation courante '00' au domaine $V_3$ correspondant à la programmation souhaitée '01'.

De la même manière pour programmer le deuxième bit 'bit2' à '0', si le premier bit 'bit1' est lu à '1', il y a lieu de passer du domaine $V_0$ correspondant à la programmation courante '11' au domaine $V_1$ correspondant à la programmation souhaitée '10'. Par contre, si le premier bit 'bit1' est lu à '0', il n'y a pas besoin de programmation supplémentaire afin de rester dans le domaine $V_2$ correspondant à la programmation souhaitée '00'.

De manière similaire, lors d'une opération de lecture du deuxième bit 'bit2', la tension V_cellule présente sur la cellule est mesurée et comparée aux valeurs de référence pour en déduire la valeur du deuxième bit.

L'étude de Y. Cai et al. "Error Analysis and Retention-aware Error Management for NAND Flash Memory," Intel Technology Journal, Volume 17, Issue 1, pp. 140-164, 2013, a démontré que dans le cas des mémoires flash de type MLC NAND avec 2 bits par cellule, les combinaisons de bits '00' et '01' correspondant aux tensions de seuil les plus élevées (domaines $V_2$ et $V_3$ sur la figure 1) sont les plus vulnérables aux erreurs, et que c'est le premier bit de ces combinaisons qui en étant égal à '0' est le plus vulnérable. L'homme du métier pourra se reporter à l'intégralité de cet article pour lire les détails de l'étude. Dans le cas d'une telle mémoire, il est compréhensible d'essayer d'éviter le plus possible la programmation de la combinaison '01' dans les cellules mémoire. La valeur '0' est alors considérée comme une valeur vulnérable pour le premier bit et la valeur '1' est considérée comme une valeur vulnérable pour le deuxième bit. Cependant, l'homme du métier comprend qu'il s'agit d'un exemple mais qu'une autre convention pourrait être choisie pour définir les combinaisons des bits par domaine, comme par exemple, une convention qui fixerait respectivement le domaine $V_0$ à '11', le domaine $V_1$ à '10', le domaine $V_2$ à '00' et le domaine $V_3$ à '01', comme illustré sur la figure 1. Le principe démontré que la vulnérabilité aux erreurs dépend de la valeur qui est à stocker et de la ou des valeurs déjà stockée(s) dans une cellule ou dans des cellules voisines reste vrai.

Ainsi, il est à noter qu'une grande majorité des mémoires est asymétrique par rapport à la vulnérabilité aux erreurs. Dans le cas des mémoires binaires, ce sont soit les bits '0', soit les bits '1' qui peuvent être plus vulnérables. Dans le cas d'une mémoire vive dynamique (DRAM) pour « Dynamic Random Access Memory » en anglais, les bits '1' sont, en général, plus vulnérables que les bits '0' et il peut y avoir jusqu'à quatre décades de différence entre les vulnérabilités des deux valeurs, comme cela est expliqué par K. Kraft et al. dans "Efficient Coding Scheme for DDR4 Memory Subsystems," MEMSYS, pp. 148-157, 2018.

Dans le cas des mémoires de type magnétique à transfert de spin (STT-MRAM) pour « Spin-Transfer Torque Magnetoresistive Random-Access Memory » en anglais, les '1' sont plus vulnérables aux erreurs que les '0' et il peut y avoir trois décades de différence entre les taux d'erreur affectant les deux valeurs. Ceci est détaillé par Y. Emre et al. dans "Enhancing the reliability of STT-RAM throught Circuit and System Level Techniques," IEEE Workshop on Signal Processing Systems, pp. 125-130, 2012, et par C. Yang et al. dans "Improving reliability of non-volatile memory technologies through circuit level techniques and error control coding," EURASIP Journal on Advances in Signal Processing, 2012:211, 2012.

Quand la différence entre les taux d'erreur affectant des valeurs différentes stockées dans une mémoire est de plusieurs décades, il est couramment considéré que la mémoire n'est affectée que par des erreurs unidirectionnelles et il est possible d'utiliser des codes détecteurs d'erreur permettant la détection des toutes les erreurs unidirectionnelles dans un mot mémoire. Cependant, comme ces codes ne font que la détection d'erreur mais ne permettent pas la correction d'erreur, une telle approche n'est applicable que dans le cas des mémoires cache dont les données hébergées possèdent une réplique stockée ailleurs. Le document de N. Sayed, F. Oboril, R. Bishnoi and M.B. Tahoori, "Leveraging Systematic Unidirectional Error-Detecting Codes for fast STT-MRAM Cache," IEEE VLSI Test Symposium, pp. 1026 - 1032, 2017, décrit cette approche.

Une manière courante d'améliorer la performance des mémoires (SRAMs, mémoires cache, DRAMs, Flash...) est de diminuer leur taux d'erreur. Pour réduire le taux d'erreur, une solution consiste à inverser les mots à écrire en mémoire avant leur stockage s'ils ont un nombre trop grand de valeurs vulnérables. Il est nécessaire d'ajouter un bit supplémentaire par mot mémoire afin d'indiquer l'état d'inversion du mot. Une telle solution peut être rencontrée sous l'indication « inversion sélective des mots mémoire » (ISMM) et le bit ajouté pour indiquer l'état d'inversion d'un mot mémoire est appelé « bit d'inversion ».

La technique ISMM peut être combinée avec l'utilisation d'un code correcteur d'erreurs (ECC pour « Error Correcting Code » en anglais permettant la détection et la correction d'erreurs) qui encode les données avant leur écriture en mémoire. Lors de l'encodage de données avec un code ECC, des bits de vérification sont ajoutés aux bits de données, les bits de vérification représentant une information redondante calculée à partir des bits de données qui permet la détection et la correction des erreurs affectant aussi bien les bits de données que les bits de vérification. L'ensemble des bits de données et des bits de vérification forme un mot de code. Dans le cas où un bit d'inversion est rajouté aux bits de données ce bit est traité comme un bit de données supplémentaire lors de l'encodage et du décodage du ECC, et fait partie du mot de code. Bien que des réductions d'erreurs significatives soient rapportées dans la littérature par l'utilisation de la technique ISMM combinée avec un ECC pour des mémoires DDR4 (voir l'article précédemment cité de K. Kraft et al. "Efficient Coding Scheme for DDR4 Memory Subsystems," MEMSYS, pp. 148-157, 2018), il ressort que la décision d'inverser un mot de code avant l'écriture en mémoire est prise uniquement en fonction du nombre de valeurs vulnérables parmi les bits de données, et ne prend pas en compte l'ensemble des valeurs potentiellement vulnérables d'un mot de code qui comprend les bits de données, le bit d'inversion et les bits de vérification.

Aussi, un objet de l'invention est de pallier les inconvénients des techniques connues pour réduire le taux d'erreur des mémoires.

A cet effet, l'invention a pour objet une solution qui vise à améliorer la fiabilité des mémoires, par la mise en œuvre d'une opération d'inversion sélective des mots de code, la décision d'inverser un mot étant prise en fonction d'un nombre de valeurs vulnérables qui est déterminé à partir des bits de données, du bit d'inversion et de certains bits de vérification.

Pour parvenir au but recherché, il est proposé un procédé d'inversion sélective d'un mot à écrire dans une mémoire, la mémoire comprenant des cellules mémoire où chaque cellule mémoire permet de stocker au moins deux valeurs associées à au moins un bit. Le procédé d'inversion sélective comprend au moins les étapes suivantes :

- associer un bit d'inversion à une pluralité k de bits de données d'un mot de données à écrire dans la mémoire, le bit d'inversion ayant une valeur prédéfinie indiquant un état de non-inversion des k bits de données ;

- calculer avec un code correcteur d'erreur à partir des k bits de données et du bit d'inversion, un nombre r de bits de vérification, les r bits de vérification comprenant des bits de vérification pairs s et des bits de vérification impairs r-s, et tel que l'ensemble des k bits de données, du bit d'inversion et des r bits de vérification pairs et impairs forme un mot de code v1 de k+1+r bits à mémoriser dans la mémoire;

- définir, si non prédéfini, parmi les cellules mémoire destinées à mémoriser le mot de code, un nombre y de cellules dîtes sensibles pour lesquelles les valeurs des bits mémorisés dans ces cellules sont susceptibles de correspondre à des valeurs vulnérables ;

- déterminer parmi les bits dudit mot de code v1 destinés à être mémorisés sur lesdites y cellules sensibles :

    -- un nombre n1 de bits d'intérêt présentant une valeur vulnérable et pour lesquels une opération d'inversion dudit mot de code conduirait à l'obtention d'une valeur non vulnérable ; et/ou
    -- un nombre n2, correspondant dans ledit mot de code et parmi les bits destinés à être mémorisés sur lesdites y cellules sensibles, au nombre de bits pour lesquels une opération d'inversion du mot de code conduirait à l'obtention d'une valeur vulnérable ;

- évaluer les nombres n1 et/ou n2 pour décider d'inverser ou non le mot de code ; et

- si l'opération d'inverser est décidée, inverser dans le mot de code : les k bits de données, le bit d'inversion et les r-s bits de vérification impairs pour obtenir un nouveau mot de code v2.

Selon des modes de réalisation alternatifs ou combinés :

- l'étape d'évaluation des nombres n1 et/ou n2 consiste à comparer le nombre n1 de bits d'intérêt obtenu à un nombre prédéfini z, ledit nombre prédéfini z caractérisant un seuil où ledit mot de code contient après une opération d'inversion plus de bits présentant une valeur vulnérable que le mot de code avant inversion.

- l'étape de détermination du nombre n1 de bits d'intérêt consiste à rechercher les valeurs vulnérables uniquement parmi les k bits de données, le bit d'inversion et les r-s bits de vérification impairs et dans lequel, le nombre z est prédéfini en considérant le nombre de cellules mémoire sensibles susceptibles de mémoriser l'un des k bits de données, le bit d'inversion ou l'un des r-s bits de vérification impairs.

- les cellules mémoire sont prévues pour stocker chacune 1 bit peuvent prendre deux valeurs « 0 » ou « 1 », et une des valeurs est plus vulnérable que l'autre car elle présente une plus grande probabilité de se changer et devenir l'autre des deux valeurs.

- le nombre y de cellules sensibles est prédéfini et correspond par exemple à l'ensemble des cellules destinées à mémoriser le mot de code.

- chaque cellule mémoire est susceptible de stocker plusieurs bits susceptibles chacun de prendre deux valeurs codant au moins quatre états possibles de la cellule mémoire, chaque cellule mémoire est susceptible de stocker au moins deux bits appartenant à au moins deux mots de code différents, et chaque cellule présente au moins un état vulnérable codé par des valeurs correspondantes, dites vulnérables, desdits au moins deux bits ; et l'étape de définition des y cellules sensibles consiste à prendre en compte les valeurs prises par les bits des autres mots de code déjà stockés dans les cellules mémoire destinées à mémoriser le mot de code à écrire.

- l'étape de définition des y cellules sensibles comprend les étapes suivantes :

- lire les autres mots de codes déjà mémorisés dans les cellules mémoire destinées à mémoriser ledit mot de code à écrire ;

- définir, pour chaque bit des autres mots de codes déjà mémorisés, si la valeur associée correspond à une valeur vulnérable prédéfinie et si c'est le cas, définir la cellule considérée comme une cellule sensible.

- le procédé comprend de plus une étape d'écrire dans la mémoire soit le mot de code v1 non-inversé, soit ledit nouveau mot de code v2.

- le procédé comprend de plus une étape de lire un mot de code stocké dans la mémoire selon les étapes du procédé d'inversion sélective revendiqué.

L'invention couvre aussi un dispositif d'inversion sélective d'un mot à écrire dans une mémoire, la mémoire comprenant des cellules mémoire où chaque cellule mémoire permet de stocker au moins deux valeurs associées à au moins un bit, le dispositif comprenant des moyens permettant de mettre en œuvre les étapes du procédé d'inversion sélective revendiqué.

Selon des modes de réalisation alternatifs ou combinés :

- le dispositif comprend de plus des moyens pour lire un mot stocké dans la mémoire et pour déterminer si le mot stocké est inversé ou non.

- la mémoire est constituée d'une pluralité de cellules mémoire mono-niveau contenant un seul bit d'information qui peut prendre deux états électriques possibles, ou est constituée d'une pluralité de cellules mémoire multi-niveaux capables de stocker plus d'un bit d'information et prendre plus de deux états électriques.

- les moyens revendiqués comprennent un code correcteur d'erreur qui a une ou plusieurs des caractéristiques d'être linéaire, binaire, de type bloc et/ou systématique.

L'invention a aussi pour objet un programme d'ordinateur comportant des instructions de code pour l'exécution des étapes du procédé d'inversion sélective revendiqué, lorsque ledit programme est exécuté par un processeur.

D'autres caractéristiques, détails et avantages de l'invention ressortiront à la lecture de la description faite en référence aux dessins annexés donnés à titre d'exemple et qui représentent, respectivement :

   [Fig.1] une illustration de la distribution de la tension dans une mémoire Flash de type MLC capable de stocker deux bits par cellule ;

   [Fig.2] les étapes d'un procédé d'inversion sélective selon un mode de réalisation de l'invention ;

   [Fig.3] une illustration d'une matrice de parité H pour un code correcteur d'erreur ECC avec 3 bits de données;

   [Fig.4] un mode de réalisation d'un dispositif permettant de mettre en œuvre les étapes du procédé d'inversion sélective de l'invention;

   [Fig.5] les étapes d'un procédé d'écriture d'un mot dans une mémoire selon un mode de réalisation du procédé d'inversion sélective de l'invention ;

   [Fig.6] les étapes d'un autre procédé d'écriture d'un mot dans une mémoire selon un mode de réalisation du procédé d'inversion sélective de l'invention ;

   [Fig.7] les étapes d'un procédé pour lire un mot d'une mémoire selon un mode de réalisation de l'invention; et

   [Fig.8] un mode de réalisation d'un dispositif permettant de mettre en œuvre les étapes du procédé de lecture de l'invention.

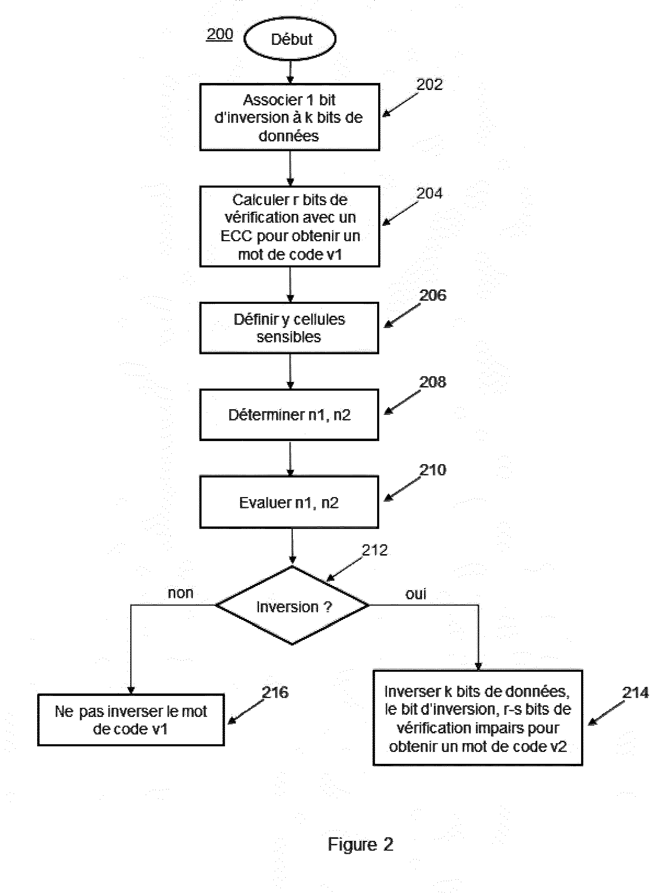

La figure 2 présente un exemple de procédé 200 d'inversion sélective selon l'invention. Le procédé général qui est décrit s'applique à différents types de mémoires, que ce soit des mémoires avec des cellules SLC, MLC ou TLC. Ainsi la mémoire peut comprendre une pluralité de cellules mémoire où chaque cellule mémoire permet de stocker au moins deux valeurs associées à au moins un bit.

Le procédé 200 utilise comme entrées k bits de données composant un mot mémoire qui doit être écrit à une adresse définie de la mémoire. Dans une première étape 202, le procédé permet d'associer un bit d'inversion aux k bits de données du mot mémoire. Une valeur prédéfinie est attribuée au bit d'inversion afin de caractériser l'état de non inversion initial du mot mémoire.

Dans une étape suivante 204, le procédé permet avec un code correcteur d'erreur ECC de calculer à partir des k bits de données et du bit d'inversion, un nombre r de bits de vérification afin d'obtenir un mot de code v1. Le bit d'inversion est traité comme tous les k autres bits de données pour l'opération d'encodage du mot de code par l'ECC.

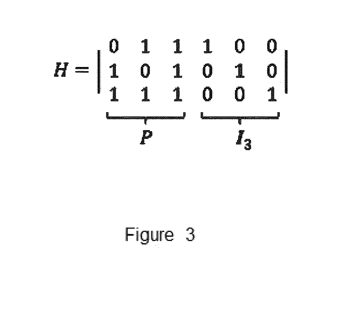

Pour rappel, les mots de code d'un code correcteur linéaire systématique sont définis à l'aide d'une matrice de parité $H = [P, I_r]$ composée d'une sous-matrice P où chaque colonne correspond à des bits de données, et d'une sous-matrice d'identité $I_r$ où chaque colonne correspond à des bits de vérification. La figure 3 illustre une matrice de parité H pour un code correcteur d'erreur avec 3 bits de données (k=3) et 3 bits de vérification (r=3). Les premières 3 colonnes correspondent à la sous-matrice P et les dernières 3 colonnes à la sous-matrice $I_r$ pour r égal à 3.

Un vecteur v est un mot de code seulement si son produit avec la matrice H génère un vecteur nul, tel que $H.v = 0$. Dans le cas d'un ECC systématique, chaque mot de code v est divisé en un vecteur de bits de données d et un vecteur de bits de vérification c et peut être noté :

$v = \begin{pmatrix} d \\ c \end{pmatrix}$. Il est donc possible de faire la distinction entre les bits de données et les bits de vérification, par exemple selon la notation :

$$v = \begin{pmatrix} d1 \\ d2 \\ d3 \\ c1 \\ c2 \\ c3 \end{pmatrix}.$$

La matrice P peut être utilisée pour calculer le vecteur de bits de vérification c. Dans l'exemple de la matrice de la figure 3, les bits de vérification c1 et c2 sont pairs, le bit c3 est un bit de vérification impair. On peut définir le paramètre s comme correspondant au nombre de bits de vérification pairs et le paramètre r-s comme correspondant au nombre de bits de vérification impairs. Dans le cas de la figure 3, le paramètre s est égal à 2 et le paramètre r-s est égal à 1.

Un code correcteur d'erreur est binaire si les mots de code ne contiennent que des valeurs binaires.

Un code correcteur d'erreur est un code de type bloc si les mots de code ont un nombre fixe de bits.

Lors de la lecture des données présentes dans une mémoire, chaque mot de code v est vérifié en évaluant le produit matriciel $H.v$. Le résultat de cette opération est un vecteur appelé aussi syndrome. Si le syndrome est un vecteur nul, le mot de code est considéré comme correct. Un syndrome non-nul indique la présence d'au moins une erreur. Si le syndrome permet d'identifier les positions des bits affectés, le mot de code peut être corrigé.

Différents ECCs linéaires peuvent être mis en œuvre avec des capacités de détection et de correction d'erreurs différentes. A titre d'exemple, le codage de Hamming permet de corriger une erreur simple, c'est-à-dire une erreur qui affecte un seul bit. Cette capacité de correction est qualifiée de SEC, acronyme venant de l'expression anglo-saxonne « Single Error Correction ».

Un autre exemple de code ECC est le code DEC, acronyme venant de l'expression anglo-saxonne «Double Error Correction». Un code DEC permet la correction d'erreurs doubles, c'est-à-dire d'erreurs affectant deux bits dans un mot de code.

Revenant à l'étape 204, les r bits de vérification d'un ECC de type bloc qui est linéaire, systématique et binaire peuvent être classés en s bits de vérification pairs et r-s bits de vérification impairs, tel que l'ensemble des k bits de données, du bit d'inversion et des r bits de vérification pairs et impairs forme un mot de code v1 de k+1+r bits à mémoriser dans la mémoire. L'homme de l'art connait qu'une définition des bits de vérification pairs et impairs, est qu'un bit de vérification est appelé impair si sa valeur s'inverse quand tous les bits de données sont inversés, et que dans le cas contraire, le bit de vérification est appelé pair.

Dans une étape suivante 206, le procédé permet si cela n'a pas été prédéfini, de définir un nombre y de cellules mémoires considérées comme sensibles, parmi les cellules mémoire destinées à mémoriser le mot de code v1. Les cellules sensibles sont celles pour lesquelles les valeurs des bits mémorisés dans ces cellules sont susceptibles de correspondre à des valeurs vulnérables, selon la convention choisie.

Dans une étape suivante 208, le procédé permet de déterminer un ou deux nombres n1 et/ou n2 de bits pour lesquels une opération d'inversion du mot de code v1 conduirait respectivement à l'obtention de valeurs non vulnérables ou de valeurs vulnérables.

Dans un mode de réalisation, le nombre n1 est calculé à partir des bits du mot de code v1 destinés à être mémorisés sur les y cellules sensibles, et consiste à déterminer n1 bits d'intérêt présentant une valeur vulnérable pour lesquels une opération d'inversion du mot de code v1 conduirait à l'obtention d'une valeur non vulnérable.

Dans un mode de réalisation, le nombre n2 est calculé à partir des bits du mot de code v1 destinés à être mémorisés sur les y cellules sensibles, et consiste à déterminer n2 bits (présentant une valeur vulnérable ou non vulnérable) pour lesquels une opération d'inversion du mot de code v1 conduirait à l'obtention d'une valeur vulnérable qui est non souhaitée.

Dans une étape suivante 210, le procédé permet d'évaluer les valeurs obtenues de l'un n1 ou de chacun des deux nombres n1 et n2.

Dans un mode de réalisation, l'étape d'évaluation des nombres n1 et/ou n2 consiste à comparer le nombre obtenu n1 de bits d'intérêt à un nombre prédéfini z caractérisant un seuil où un mot de code de k+1+r bits contient après une opération d'inversion plus de bits présentant une valeur vulnérable que le mot de code avant inversion.

Dans un mode de réalisation, la détermination du nombre n1 de bits d'intérêt consiste à rechercher les valeurs vulnérables uniquement parmi les k bits de données, le bit d'inversion et les r-s bits de vérification impairs avec le nombre z prédéfini.

Dans un mode de réalisation, le nombre y de cellules sensibles est prédéfini et correspond à l'ensemble des cellules destinées à mémoriser le mot de code.

Les recherches des inventeurs leur ont permis de constater que le résultat d'une opération d'inversion d'un mot de code par une approche ISMM, dépend de la présence et du nombre de bits de vérification pairs et de bits de vérification impairs, mais que seules les valeurs prises par les bits de vérification impairs ont un effet sur le nombre de valeurs vulnérables après inversion. Aussi, le nombre de valeurs vulnérables prises par les bits de vérification paires n'a pas besoin d'être pris en compte dans l'étape de détermination 208 des nombres n1 et/ou n2.

Avantageusement, le procédé de l'invention en comptant uniquement le nombre de bits de vérification impairs dans le processus de détermination d'inversion, réduit le nombre de bits pour lesquels il faut déterminer si la valeur est vulnérable, ce qui permet de diminuer le temps d'exécution de cette opération, et ainsi de réduire la latence d'une opération d'écriture en mémoire.

Un autre avantage du procédé de l'invention réside dans le fait que la connaissance du nombre de bits de vérification pairs permet d'ajuster précisément le seuil utilisé pour le nombre prédéfini z, pour décider si un mot de code doit être inversé avant son écriture en mémoire. Avantageusement, cela permet d'encore réduire le taux d'erreur qui affecte la mémoire, de réduire la complexité du procédé et la taille du dispositif utilisé pour effectuer une opération d'écriture mémoire.

Le résultat de l'étape d'évaluation 210, consiste à déterminer 212 si le mot de code doit être inversé ou non. Si l'inversion est requise, le procédé passe à l'étape suivante 214 pour inverser dans le mot de code, les k bits de données, le bit d'inversion et les r-s bits de vérification impairs et obtenir un nouveau mot de code v2.

Si l'inversion n'est pas nécessaire, le procédé conserve le mot de code v1 initial non inversé 216.

Dans une étape ultérieure, le procédé permet d'écrire en mémoire à l'adresse prédéfinie, soit le mot de code v1 non inversé, soit le mot de code v2 inversé.

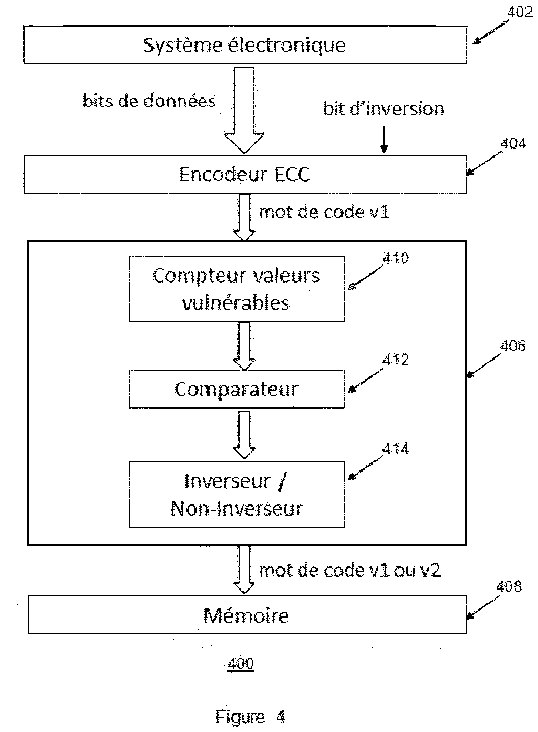

La figure 4 montre un exemple de réalisation d'un dispositif 400 permettant de mettre en œuvre les étapes du procédé 200 d'inversion sélective de l'invention. Le dispositif peut être utilisé pour faire un transfert de données d'un système électronique 402 vers une mémoire 408 où les bits de données sont stockés après application du procédé d'inversion. Les données à écrire sont fournies par un système électronique 402, qui peut être un circuit à base de processeur, de multiprocesseur, de FPGA (acronyme de « Field-Programmable Gate Array » en anglais) ou d'ASIC (acronyme de « Application Specific Integrated Circuit » en anglais). Dans un mode de réalisation, le système électronique 402 peut être un contrôleur mémoire implémenté dans un système de stockage. Dans un mode de réalisation, le système électronique fournit les k bits de données et le bit d'inversion indiquant l'état de non-inversion du mot mémoire initial est ajouté. Alternativement, les données fournies par le système électronique contiennent l'ensemble des k bits de données et du bit d'inversion. Le dispositif comprend un circuit code correcteur d'erreur ECC 404 apte à recevoir des données du système électronique, à encoder les données en calculant des bits de vérification à partir des bits de données et du bit d'inversion, et à générer un mot de code v1 comprenant k bits de données, 1 bit d'inversion et r bits de vérification dont s bits de vérification pairs et r-s bits de vérification impairs. Selon différents modes de réalisation de l'invention, le code correcteur d'erreur ECC présente toutes ou certaines des caractéristiques suivantes :

- le code est linéaire ;
- le code est binaire ;
- le code est un code de type bloc ;
- le code est systématique.

Le dispositif 400 comprend de plus un module de détermination d'inversion 406 composé d'un compteur de valeurs vulnérables 410, d'un comparateur 412 et d'un module d'inversion 414. Le module de détermination d'inversion 406 est configuré pour opérer les étapes de la figure 2, et en particulier, les étapes 206 et 208 avec le compteur 410, l'étape 210 avec le comparateur 412 et les étapes 212 à 216 avec le module d'inversion 414.

Le dispositif 400 est simplifié pour n'illustrer que les modules fonctionnels permettant d'opérer le procédé d'inversion de l'invention, sans être limitatif. Aussi des variantes de réalisation peuvent être apportées quant à l'implémentation des différents modules. Ainsi par exemple, le code correcteur d'erreur 404 peut être un module externe ou être intégré à la mémoire 408.

Dans un mode de réalisation, la mémoire 408 est organisée en une pluralité de cellules mémoire, où chaque cellule mémoire permet de stocker 1 bit pouvant prendre deux valeurs « 0 » ou « 1 », et où une des valeurs est plus vulnérable que l'autre car elle présente une plus grande probabilité de se changer et devenir l'autre des deux valeurs.

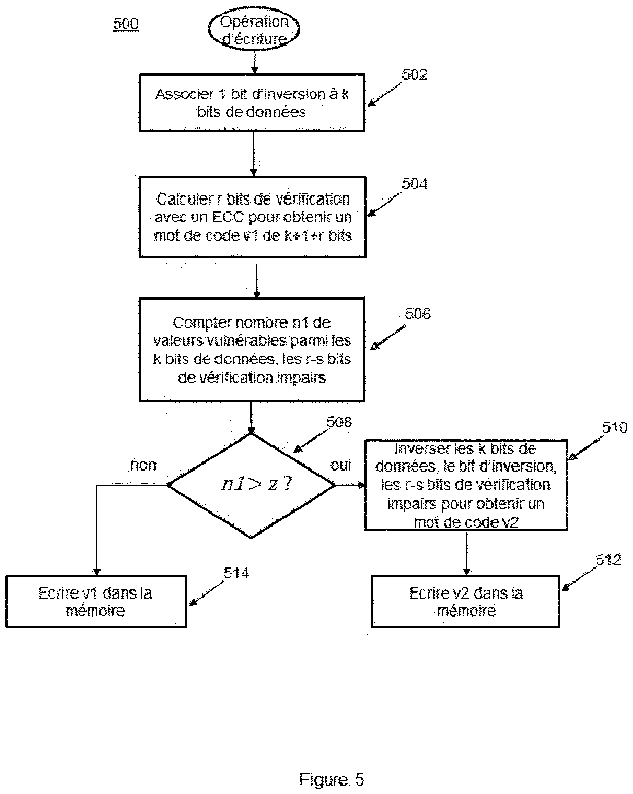

La figure 5 décrit les étapes d'un procédé d'écriture d'un mot dans une telle mémoire selon un mode de réalisation du procédé d'inversion sélective 300 de l'invention.

Le procédé 500 débute par les étapes 502 et 504 identiques respectivement aux étapes 202 et 204 du procédé de la figure 2, où à l'étape 502 le procédé permet d'associer un bit d'inversion avec une valeur prédéfinie caractérisant l'état de non inversion initial du mot mémoire, et où à l'étape suivante 504, le procédé permet de calculer à partir des k bits de données et du bit d'inversion, un nombre r de bits de vérification avec s bits de vérification pairs et r-s bits de vérification impairs, afin d'obtenir un mot de code v1 de k+1+r bits. Dans ce mode de réalisation, toutes les cellules mémoire dans lesquelles un mot de code doit être écrit, sont considérées comme des cellules sensibles.

L'étape suivante 506 consiste à compter le nombre n1 de valeurs vulnérables parmi les k bits de données, les r-s bits de vérification impairs.

A l'étape suivante 508, le procédé permet de comparer le nombre n1 obtenu à un nombre z caractérisant un seuil au-delà duquel un mot de code de k+1+r bits contient après une opération d'inversion plus de bits présentant une valeur vulnérable que le mot de code avant inversion.

Dans le cas où il n'est pas affecté une valeur vulnérable au bit d'inversion, le seuil de comparaison est

$$z = \frac{k+1+r-s}{2} \quad (1).$$

Dans le cas où il est affecté une valeur vulnérable au bit d'inversion, le seuil de comparaison est

$$z = \frac{k-1+r-s}{2} \quad (1').$$

Si le résultat de la comparaison est que n1 est supérieur au seuil (1) ou (1'), signifiant que le nombre de valeurs vulnérables sans inversion est plus grand que le seuil de référence, le procédé se poursuit à l'étape 510 pour inverser dans le mot de code v1, les k bits de données, le bit d'inversion et les r-s bits de vérification impairs afin de générer un nouveau mot de code v2. Les valeurs des s bits de vérification pairs ne sont pas changées afin d'obtenir un mot de code après le processus d'inversion.

Suite à l'inversion des bits mentionnés, le nombre de valeurs vulnérables n' parmi les bits de données, le bit d'inversion et les bits de vérifications impairs est alors défini par l'expression suivante :

$$n' = k + 1 + r - s - n1 \quad (2).$$

En combinant l'expression (2) avec l'expression $n1 > \frac{k+1+r-s}{2}$, on obtient l'expression suivante :

$$n' < \frac{k+1+r-s}{2} \quad (3)$$

qui signifie que n' < n1 donc que le mot de code v2 obtenu après inversion contient moins de valeurs vulnérables que le mot de code v1 initial avant inversion.

Le procédé se termine par une étape 512 d'écriture du mot de code v2 à l'emplacement mémoire défini.

Revenant à l'étape 508 de comparaison, si le nombre n1 obtenu est inférieur au seuil z défini (1) ou (1'), signifiant que le mot de code v1 n'a pas besoin d'être inversé, le procédé se termine par une étape 514 d'écriture du mot de code v1 à l'emplacement mémoire défini.

Avantageusement, le procédé de la figure 5 peut être mis en œuvre sur le dispositif 400 décrit en référence à la figure 4 pour la programmation à une adresse spécifiée d'un premier mot dans des cellules mémoire multi-niveaux.

Dans une variante de réalisation, la mémoire 408 est organisée en une pluralité de cellules mémoire, où chaque cellule mémoire permet de stocker plusieurs bits susceptibles chacun de prendre deux valeurs codant au moins quatre états possibles de la cellule mémoire, chaque cellule mémoire est susceptible de stocker au moins deux bits appartenant à au moins deux mots de code différents, et chaque cellule présente au moins un état vulnérable codé par des valeurs correspondantes dites valeurs vulnérables desdits au moins deux bits. Dans cette configuration de mémoire, le procédé de l'invention peut être opéré pour la programmation d'un mot dans des cellules mémoire qui contiennent déjà un mot de code.

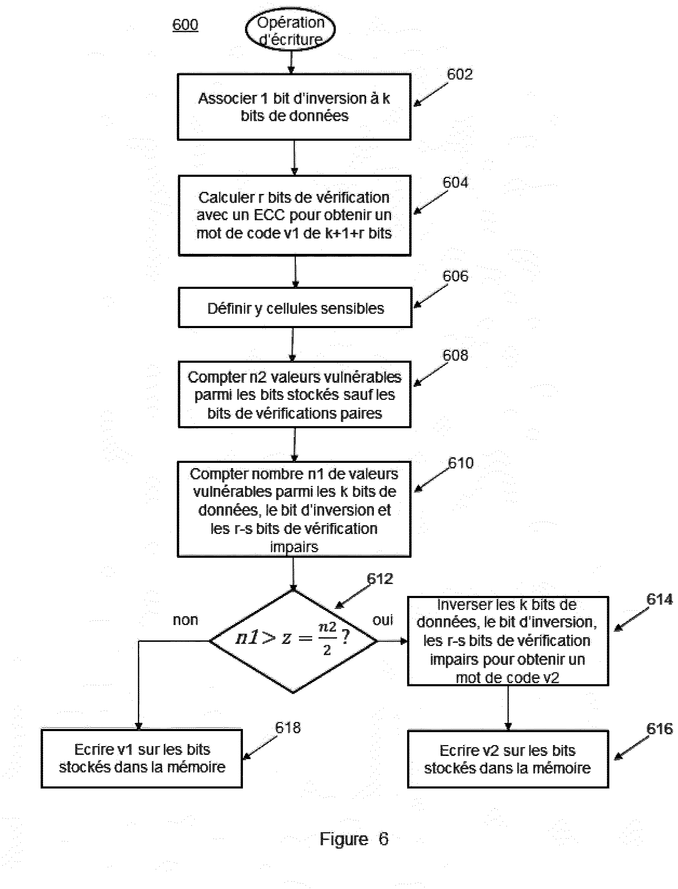

La figure 6 décrit les étapes selon un mode de réalisation du procédé d'inversion sélective de l'invention, pour écrire un mot dans des cellules mémoire qui contiennent déjà au moins un mot de code stocké et qui permettent le stockage d'au moins un mot de code supplémentaire.

Le procédé 600 débute par les étapes 602 et 604 identiques respectivement aux étapes 202 et 204 du procédé de la figure 2, où à l'étape 602 le procédé permet d'associer à k bits de données d'un nouveau mot mémoire, un bit d'inversion avec une valeur prédéfinie caractérisant l'état de non inversion initial du nouveau mot mémoire à écrire, et où à l'étape suivante 604, le procédé permet de calculer à partir des k bits de données et du bit d'inversion, un nombre r de bits de vérification avec s bits de vérification pairs et r-s bits de vérification impairs, afin d'obtenir un mot de code v1 de k+1+r bits.

Le procédé se poursuit à l'étape 606 pour définir un nombre y de cellules sensibles en prenant en compte les valeurs prises par les bits du mot ou des mots de code déjà stockés dans les cellules mémoire destinées à mémoriser le mot de code à écrire. L'identification des y cellules sensibles consiste à lire le mot ou les mots de codes déjà mémorisés dans les cellules mémoire destinées à mémoriser le mot de code à écrire, et à définir, pour chaque bit des autres mots de codes déjà mémorisés., si les valeurs associées aux bits déjà mémorisés sont vulnérables, et si c'est le cas, définir la cellule considérée comme une cellule sensible.

A l'étape suivant 608, le procédé permet de compter le nombre n2 de valeurs vulnérables parmi les bits déjà stockés à l'exception des bits de vérifications paires, puis à l'étape suivante 610, le procédé permet de compter le nombre n1 de valeurs vulnérables parmi les k bits de données, le bit d'inversion et les r-s bits de vérification impairs du mot à écrire qui doivent être stockées dans une cellule sensible.

Dans une étape suivante 612, le procédé permet de comparer le nombre n1 à un seuil z qui est fixé à la moitié de la valeur du nombre n2 précédemment calculé. Si le résultat de la comparaison est que n1 est supérieur à $\frac{n2}{2}$, le procédé se poursuit à l'étape 614 pour inverser dans le mot à écrire, les k bits de données, le bit d'inversion, les r-s bits de vérification impairs et obtenir un mot de code v2.

Le procédé se termine par une étape 614 d'écriture du mot de code v2 à l'emplacement mémoire où un mot est déjà stocké.

Si le résultat de la comparaison est que n1 est plus petit que $\frac{n2}{2}$, signifiant que le mot de code n'a pas besoin d'être inversé, le procédé se termine par l'étape 618 d'écriture du mot de code v1 à l'emplacement mémoire où un mot est déjà stocké.

Dans un mode de réalisation, le procédé 600 peut être mis en œuvre sur le dispositif 400 décrit en référence à la figure 4.

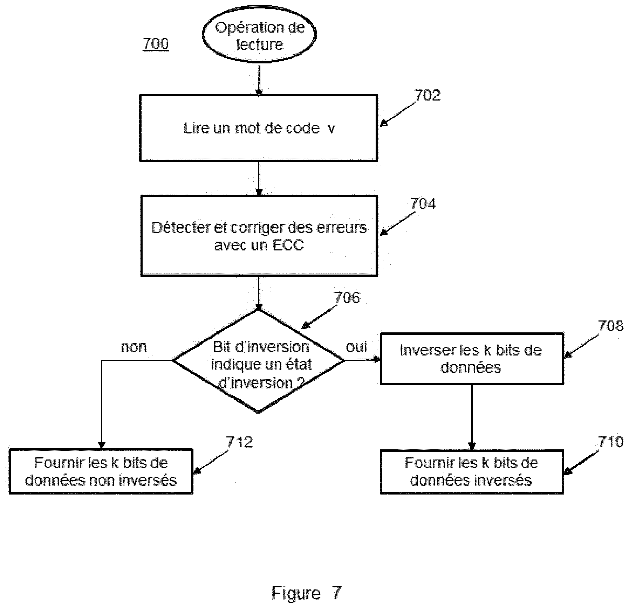

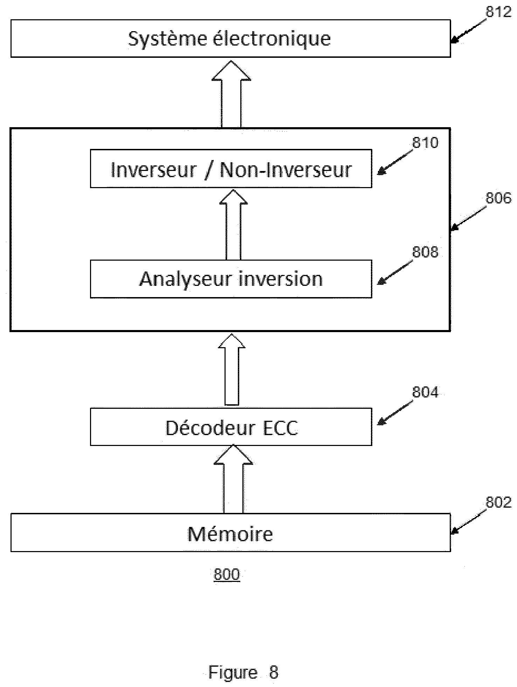

La figure 7 montre un enchainement d'étapes d'un procédé de lecture 700 d'un mot stocké en mémoire selon les principes de l'invention, et la figure 8 montre un mode de réalisation d'un dispositif permettant de mettre en œuvre les étapes du procédé de lecture de la figure 7. Le procédé débute à la réception 702 d'une requête de lecture d'un mot de code v stocké à une adresse mémoire. Le mot de code comprend une pluralité k de bits de données, un bit d'inversion et des bits de vérification pairs et impairs stockés dans une mémoire 802 après l'exécution de l'un des procédés 200, 500 ou 600 précédemment décrits. Le procédé permet par un code correcteur d'erreur 804 de détecter des erreurs et le cas échéant les corriger 704. Puis le procédé permet par un module d'analyse d'inversion 808 de vérifier la valeur du bit d'inversion 706 afin de déterminer si le mot de code a été stocké après une inversion ou non. Si la valeur du bit d'inversion signifie qu'une inversion a eu lieu pour le stockage du mot de code, le procédé permet par un circuit d'inversion 810 d'inverser 708 tous les bits de données du mot de code et de fournir à un système électronique 812 les bits de données initiaux 710. Si la valeur du bit d'inversion signifie qu'il n'y a pas eu d'inversion pour le stockage du mot de code, le procédé permet de fournir 712 directement les bits de données stockés au système électronique sans les inverser.

Dans un mode de réalisation, le mot de code qui est inversé 708 peut être reprogrammé en mémoire soit à l'adresse initiale, soit à une autre adresse.

La présente description illustre une implémentation préférentielle de l'invention, mais qui n'est pas limitative. Des exemples sont choisis pour permettre une bonne compréhension des principes de l'invention et une application concrète, mais ne sont en rien exhaustifs et doivent permettre à l'homme du métier d'apporter des modifications et des variantes d'implémentation en conservant les mêmes principes. Ainsi par exemple, les différents procédés décrits peuvent être implémentés au sein d'un même dispositif.

L'invention peut s'implémenter à partir d'éléments matériels et/ou logiciels. Elle peut être disponible en tant que produit programme d'ordinateur exécuté par un processeur dédié ou par un contrôleur mémoire d'un système de stockage, et qui comprend des instructions de code pour exécuter les étapes des procédés dans leurs différents modes de réalisation. Dans des variantes de réalisation, chaque module fonctionnel d'encodage, de comptage, de comparaison et d'inversion peut être implémenté par un module dédié tel qu'un ASIC.

## Revendications

1. Procédé d'inversion sélective d'un mot à écrire dans une mémoire, la mémoire comprenant des cellules mémoire où chaque cellule mémoire permet de stocker au moins deux valeurs associées à au moins un bit, le procédé d'inversion sélective comprenant au moins les étapes suivantes :

   - associer un bit d'inversion à une pluralité k de bits de données d'un mot de données à écrire dans la mémoire, le bit d'inversion ayant une valeur prédéfinie indiquant un état de non-inversion des k bits de données ;
   - calculer avec un code correcteur d'erreur à partir des k bits de données et du bit d'inversion, un nombre r de bits de vérification, les r bits de vérification comprenant des bits de vérification pairs s et des bits de vérification impairs r-s, et tel que l'ensemble des k bits de données, du bit d'inversion et des r bits de vérification pairs et impairs forme un mot de code v1 de k+1+r bits à mémoriser dans la mémoire;
   - définir, si non prédéfini, parmi les cellules mémoire destinées à mémoriser le mot de code, un nombre y de cellules dîtes sensibles pour lesquelles les valeurs des bits mémorisés dans ces cellules sont susceptibles de correspondre à des valeurs vulnérables ;
   - déterminer parmi les bits dudit mot de code v1 destinés à être mémorisés sur lesdites y cellules sensibles :

   - un nombre n1 de bits d'intérêt présentant une valeur vulnérable et pour lesquels une opération d'inversion dudit mot de code conduirait à l'obtention d'une valeur non vulnérable ; et/ou
   - un nombre n2, correspondant dans ledit mot de code et parmi les bits destinés à être mémorisés sur lesdites y cellules sensibles, au nombre de bits pour lesquels une opération d'inversion du mot de code conduirait à l'obtention d'une valeur vulnérable ;

   - évaluer les nombres n1 et/ou n2 pour décider d'inverser ou non le mot de code ; et
   - si l'opération d'inverser est décidée, inverser dans le mot de code : les k bits de données, le bit d'inversion et les r-s bits de vérification impairs pour obtenir un nouveau mot de code v2.

2. Procédé selon la revendication 1 dans lequel, l'étape d'évaluation des nombres n1 et/ou n2 consiste à comparer le nombre n1 de bits d'intérêt obtenu à un nombre prédéfini z, ledit nombre prédéfini z caractérisant un seuil où ledit mot de code contient après une opération d'inversion plus de bits présentant une valeur vulnérable que le mot de code avant inversion.

3. Procédé selon la revendication 2, dans lequel l'étape de détermination du nombre n1 de bits d'intérêt consiste à rechercher les valeurs vulnérables uniquement parmi les k bits de données, le bit d'inversion et les r-s bits de vérification impairs et dans lequel, le nombre z est prédéfini en considérant le nombre de cellules mémoire sensibles susceptibles de mémoriser l'un des k bits de données, le bit d'inversion ou l'un des r-s bits de vérification impairs.

4. Procédé selon l'une des revendications 1 ou 2, pour lequel les cellules mémoire sont prévues pour stocker chacune 1 bit pouvant prendre deux valeurs « 0 » ou « 1 », et pour lequel une des valeurs est plus vulnérable que l'autre car elle présente une plus grande probabilité de se changer et devenir l'autre des deux valeurs.

5. Procédé selon l'une des revendications précédentes, pour lequel le nombre y de cellules sensibles est prédéfini et correspond par exemple à l'ensemble des cellules destinées à mémoriser le mot de code.

6. Procédé selon la revendication 1, dans lequel chaque cellule mémoire est susceptible de stocker plusieurs bits susceptibles chacun de prendre deux valeurs codant au moins quatre états possibles de la cellule mémoire, et dans lequel chaque cellule mémoire est susceptible de stocker au moins deux bits appartenant à au moins deux mots de code différents, et dans lequel chaque cellule présente au moins un état vulnérable codé par des valeurs correspondantes dites vulnérables desdits au moins deux bits ; et dans lequel l'étape de définition des y cellules sensibles consiste à prendre en compte les valeurs prises par les bits des autres mots de code déjà stockés dans les cellules mémoire destinées à mémoriser le mot de code à écrire.

7. Procédé selon la revendication 5, dans lequel ladite étape de définition des y cellules sensibles comprend les étapes suivantes :

- lire les autres mots de codes déjà mémorisés dans les cellules mémoire destinées à mémoriser ledit mot de code à écrire ;
- définir, pour chaque bit des autres mots de codes déjà mémorisés, si la valeur associée correspond à une valeur vulnérable prédéfinie et si c'est le cas, définir la cellule considérée comme une cellule sensible.

8. Le procédé selon l'une quelconque des revendications 1 à 7 comprenant de plus une étape d'écrire dans la mémoire soit le mot de code v1 non-inversé, soit ledit nouveau mot de code v2.

9. Le procédé selon la revendication 8 comprenant de plus une étape de lire un mot de code stocké dans la mémoire selon les étapes de l'une quelconque des revendications 1 à 7.

10. Un dispositif d'inversion sélective d'un mot à écrire dans une mémoire, la mémoire comprenant des cellules mémoire où chaque cellule mémoire permet de stocker au moins deux valeurs associées à au moins un bit, le dispositif comprenant des moyens permettant de mettre en œuvre les étapes du procédé d'inversion sélective selon l'une quelconque des revendications 1 à 9.

11. Le dispositif selon la revendication 10 comprenant de plus des moyens pour écrire un mot inversé ou non inversé dans la mémoire.

12. Le dispositif selon l'une des revendications 10 ou 11 comprenant de plus des moyens pour lire un mot stocké dans la mémoire et pour déterminer si le mot stocké est inversé ou non.

13. Le dispositif selon l'une quelconque des revendications 10 à 12 où la mémoire est constituée d'une pluralité de cellules mémoire mono-niveau contenant un seul bit d'information qui peut prendre deux états électriques possibles, ou est constituée d'une pluralité de cellules mémoire multi-niveaux capables de stocker plus d'un bit d'information et prendre plus de deux états électriques.

14. Le dispositif selon l'une quelconque des revendications 10 à 12 dans lequel les moyens comprennent un code correcteur d'erreur qui a une ou plusieurs des caractéristiques d'être linéaire, binaire, de type bloc et/ou systématique.

15. Programme d'ordinateur comportant des instructions de code pour l'exécution des étapes du procédé d'inversion sélective selon l'une quelconque des revendications 1 à 9, lorsque ledit programme est exécuté par un processeur.

Figure 1

Figure 2

$$H = \begin{vmatrix} 0 & 1 & 1 & 1 & 0 & 0 \\ 1 & 0 & 1 & 0 & 1 & 0 \\ 1 & 1 & 1 & 0 & 0 & 1 \end{vmatrix}$$
$$\underbrace{\qquad\qquad}_{P} \quad \underbrace{\qquad\qquad}_{I_3}$$

Figure 3

402

Système électronique

bits de données       bit d'inversion

404

Encodeur ECC

mot de code v1

Compteur valeurs
vulnérables

410

Comparateur

412

406

Inverseur /
Non-Inverseur

414

mot de code v1 ou v2

408

Mémoire

400

Figure 4

500

Opération
d'écriture

Associer 1 bit d'inversion à k
bits de données

502

Calculer r bits de vérification
avec un ECC pour obtenir un
mot de code v1 de k+1+r bits

504

Compter nombre n1 de
valeurs vulnérables parmi les
k bits de données, les r-s bits
de vérification impairs

506

508

non          oui

$n1 > z$ ?

Inverser les k bits de
données, le bit d'inversion,
les r-s bits de vérification
impairs pour obtenir un
mot de code v2

510

Ecrire v1 dans la
mémoire

514

Ecrire v2 dans la
mémoire

512

Figure 5

600

Opération
d'écriture

Associer 1 bit d'inversion à k
bits de données — 602

Calculer r bits de vérification
avec un ECC pour obtenir un
mot de code v1 de k+1+r bits — 604

Définir y cellules sensibles — 606

Compter n2 valeurs vulnérables
parmi les bits stockés sauf les
bits de vérifications paires — 608

Compter nombre n1 de valeurs
vulnérables parmi les k bits de
données, le bit d'inversion et
les r-s bits de vérification
impairs — 610

non ← $n1 > z = \dfrac{n2}{2}$ ? — 612 → oui

Inverser les k bits de
données, le bit d'inversion,
les r-s bits de vérification
impairs pour obtenir un
mot de code v2 — 614

Ecrire v1 sur les bits
stockés dans la mémoire — 618

Ecrire v2 sur les bits
stockés dans la mémoire — 616

Figure 6

700    Opération de
       lecture

Lire un mot de code  v    702

Détecter et corriger des erreurs
avec un ECC    704

706

non    Bit d'inversion
       indique un état
       d'inversion ?    oui    Inverser les k bits de
                               données    708

Fournir les k bits de
données non inversés    712

Fournir les k bits de
données inversés    710

Figure 7

17

812

Système électronique

810

Inverseur / Non-Inverseur

806

808

Analyseur inversion

804

Décodeur ECC

802

Mémoire

800

Figure 8

Europäisches Patentamt
European Patent Office
Office européen des brevets

## RAPPORT DE RECHERCHE EUROPEENNE

Numéro de la demande

EP 20 19 3012

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2018/210669 A1 (LEE JUN-SEO [KR]) 26 juillet 2018 (2018-07-26) * page 1, alinéa 6-10 * * page 4, alinéa 68 - page 8, alinéa 128; figures 5,6,7A,7B,7C * ----- | 1-15 | INV. G06F11/10 |
| X | US 2010/287427 A1 (KIM BUMSOO [KR] ET AL) 11 novembre 2010 (2010-11-11) * page 2, alinéa 25 - page 3, alinéa 63 * * page 4, alinéa 71 - page 5, alinéa 122; figures 1-2,4-8 * ----- | 1-15 | |

DOMAINES TECHNIQUES RECHERCHES (IPC)

G06F

Le présent rapport a été établi pour toutes les revendications

| Lieu de la recherche | Date d'achèvement de la recherche | Examinateur |
|---|---|---|
| Munich | 17 décembre 2020 | Bauer, Regine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 19 3012

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

17-12-2020

| Document brevet cité au rapport de recherche | | | Date de publication | Membre(s) de la famille de brevet(s) | | | Date de publication |
|---|---|---|---|---|---|---|---|
| US 2018210669 | A1 | | 26-07-2018 | CN | 108345550 | A | 31-07-2018 |
| | | | | KR | 20180087496 | A | 02-08-2018 |
| | | | | US | 2018210669 | A1 | 26-07-2018 |
| US 2010287427 | A1 | | 11-11-2010 | CN | 101999148 | A | 30-03-2011 |
| | | | | EP | 2232501 | A1 | 29-09-2010 |
| | | | | JP | 2011508358 | A | 10-03-2011 |
| | | | | KR | 100857252 | B1 | 05-09-2008 |
| | | | | US | 2010287427 | A1 | 11-11-2010 |
| | | | | WO | 2009084797 | A1 | 09-07-2009 |

EPO FORM P0460

Pour tout renseignement concernant cette annexe : voir Journal Officiel de l'Office européen des brevets, No.12/82

# EP 3 786 801 A1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **Y. CAI et al.** Error Analysis and Retention-aware Error Management for NAND Flash Memory. *Intel Technology Journal,* 2013, vol. 17 (1), 140-164
- **K. KRAFT et al.** Efficient Coding Scheme for DDR4 Memory Subsystems. *MEMSYS,* 2018, 148-157
- **Y. EMRE et al.** Enhancing the reliability of STT-RAM throught Circuit and System Level Techniques. *IEEE Workshop on Signal Processing Systems,* 2012, 125-130
- **C. YANG et al.** Improving reliability of non-volatile memory technologies through circuit level techniques and error control coding. *EURASIP Journal on Advances in Signal Processing,* 2012, vol. 2012 (211
- **N. SAYED ; F. OBORIL ; R. BISHNOI ; M.B. TAHOORI.** Leveraging Systematic Unidirectional Error-Detecting Codes for fast STT-MRAM Cache. *IEEE VLSI Test Symposium,* 2017, 1026-1032